(19) Europäisches Patentamt
European Patent Office
Office européen des brevets

(11) EP 2 675 257 B1

(12) **EUROPEAN PATENT SPECIFICATION**

(45) Date of publication and mention of the grant of the patent:
**01.03.2017 Bulletin 2017/09**

(51) Int Cl.:
***H05K 7/20*** *(2006.01)* ***G06F 1/32*** *(2006.01)*

(21) Application number: **12172119.5**

(22) Date of filing: **15.06.2012**

(54) **Apparatus, method, and controller for regulating the flow of cooling fluid to equipment mounted in an equipment mounting structure**

Vorrichtung, Verfahren und Steuerung zur Regelung des Flusses einer Kühlflüssigkeit zu einer in einer Ausrüstungsmontagestruktur montierten Ausrüstung

Appareil, procédé et contrôleur permettant de réguler l'écoulement de fluide de refroidissement pour équipement monté dans une structure de montage de matériel

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.12.2013 Bulletin 2013/51**

(73) Proprietor: **FUJITSU LIMITED**
**Kawasaki-shi,**
**Kanagawa 211-8588 (JP)**

(72) Inventor: **Albornoz, Jose**
**Hayes, Middlesex UB4 8FE (GB)**

(74) Representative: **Hutchison, James**
**Haseltine Lake LLP**
**300 High Holborn**
**London, Greater London WC1V 7JH (GB)**

(56) References cited:
**GB-A- 2 402 816**
**US-A1- 2009 097 203**
**US-A1- 2009 122 484**
**US-A1- 2010 010 678**
**US-A1- 2010 313 203**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 675 257 B1

Printed by Jouve, 75001 PARIS (FR)

## Description

The present invention lies in the field of cooling server equipment within an enclosure such as a data centre. In particular, the present invention relates to regulating the flow of air into different sections of a mounting structure such as a rack within which equipment is mounted.

A data centre is a facility used to provide computer systems and possibly also associated components, such as data storage systems. Data centres are an essential and mission critical element in today's society and businesses. They are the base infrastructure of Cloud Computing. The use of data centres is increasing, particularly with the current trends to achieve economies of scale through centralising information processing.

Data centres use a large amount of energy, which is becoming increasingly expensive and whose production releases a large volume of $CO_2$. So the efficient design and management of data centres is important. The aim of the design and management of data centres is to deliver a reliable service while minimising energy consumption for running and cooling the computer servers and reducing carbon emissions to help the environment. Servers within data centres are mounted on structures often referred to as racks, within which servers are stacked between shelves.

In addition to servers providing computing functionality and the associated cabling and mounting structures, data centres include cooling systems for removing the heat generated by the servers in handling a workload. Cooling systems are important for keeping servers at a safe operating temperature, preventing burnout of hardware components within the server, and possibly also for optimising the operating temperature of the servers. However, operating cooling systems which exchange sufficient heat to cool an entire data centre (or subsection thereof) can consume a large amount of energy. Therefore, it is important to operate the cooling system in an efficient way - for example, by delivering cooling fluid to the equipment which requires it in preference to the equipment which does not.

There are situations in which the heat loads that a cooling system must handle change in time; examples of this are collocation data centres or virtualised environments where virtual machines are migrated or restarted in different servers. In these circumstances it is quite difficult to attain an optimum, energy-efficient airflow distribution in the data centre once deployment is complete. Perforated tiles in raised-floor ducting systems can be relocated and CRAC unit setpoints can be re-adjusted to try to reduce air conditioning power consumption while guaranteeing adequate cooling, nonetheless this is a time-consuming process that is not amenable to fast changes in heat loads such as those that can be expected in a virtualised data centre; besides, it is difficult to obtain a final outcome that is optimal in terms of energy efficiency, given the complex nature of the airflow in a data centre.

From the documents US2009/097203 A1, GB2402816A and US2009/122484 A1 apparatuses are known which regulate the flow of a cooling fluid into equipment in different sections of a mounting structure depending on the operating states of the equipments.

The document US 2010/313203 A1 discloses a system that improves the energy efficiency of a server system by reprioritization of computing jobs.

Embodiments of the present invention provide an apparatus for regulating the flow of cooling fluid to equipment mounted in an equipment mounting structure, the apparatus comprising, for each of a plurality of openings to the equipment mounting structure, each opening allowing cooling fluid to flow into a different section of the equipment mounting structure and in fluid communication with a cooling fluid inlet of equipment when said equipment is mounted within that section: a valve selectively configurable to control the rate of cooling fluid flowing through the opening; and a cooling fluid flow regulator coupled to the valve and operable to configure the coupled valve in accordance with received control signals generated in dependence upon indications of operating states of equipment mounted within the section into which the opening allows cooling fluid to flow.

Embodiments of the present invention can be used in any facility where controlled cooling of rack-mounted equipment is required with minimum energy consumption. Examples of such implementations are recording studios, communication centres, and scientific instrumentation. Furthermore, the equipment mounting structure may be a server equipment mounting structure or rack, and the mounted equipment within each section may be a server device or server equipment.

The apparatus embodying the present invention may be an apparatus for regulating the flow of cooling fluid to server equipment mounted in a server equipment mounting structure, the apparatus comprising, for each of a plurality of openings to the server equipment mounting structure, each opening allowing cooling fluid to flow into a different section of the server equipment mounting structure and in fluid communication with a cooling fluid inlet of server equipment when said server equipment is mounted within that section: a valve selectively configurable to control the rate of cooling fluid flowing through the respective opening; and a cooling fluid flow regulator coupled to the valve and operable to configure the coupled valve in accordance with received control signals generated in dependence upon indications of operating states of server equipment mounted within the section into which the opening allows cooling fluid to flow.

Advantageously, embodiments of the present invention enable a regulated flow rate of cooling fluid to enter each section of an equipment mounting structure in an individual fashion according to the reported operating states of mounted equipment within that section of the equipment mounting structure. Thereby appropriate cooling is guaranteed with a minimum energy expense in generating the cooling fluid. Regulating the flow of cooling fluid into different openings by configuring a valve in response to control signalling enables the amount of heat removed from mounted equipment to be adjusted quickly, easily, and responsively to changes in operating states of the mounted equipment. No manual physical manipulation of the cooling fluid regulating apparatus or cooling fluid distribution system is required in order to change the amount of cooling fluid being supplied to different sections of the equipment mounting structure. Furthermore, by providing an apparatus which regulates the flow of cooling fluid into the equipment mounting structure, equipment can be installed into or removed from the equipment mounting structure without disturbing the flow of cooling fluid into different sections of the structure.

Regulating the flow of cooling fluid may be taken to mean controlling the amount of cooling fluid at a certain point or through a particular opening on an ongoing basis. That is to say, regulating the flow of cooling fluid is not merely making initial settings that affect the flow of cooling fluid, but providing an apparatus that is adjustable during its use and hence responsive to changes in operating states of equipment to which the cooling fluid is being supplied. Advantageously, regulating the flow of cooling fluid in accordance with embodiments of the present invention obviates the need for manual manipulation of apparatus to respond to changes in operating states in mounted equipment to which cooling fluid is being supplied. Therefore embodiments of the present invention can alter flow rates quickly and in response to small changes in operating states. Embodiments of the present invention are particularly suitable for virtualised computing environments in which the workload handled by any particular server can change frequently.

Mounted equipment may be one or more individual servers housed within a rack, and may be placed on shelves in a rack which shelves defines the different sections of the rack. The rack may have openings at a front side into which the valves control flow of cooling fluid, and may be open at a rear side for exhaust of cooling fluid having passed through equipment mounted on the rack, and to enable cabling to be connected to the mounted equipment.

A cooling fluid inlet being in fluid communication with one or more cooling fluid inlets of mounted equipment may be taken to mean that the opening and the inlets are configured or positioned so that cooling fluid flowing through the opening is contained so that it can be pulled into the one or more inlets with little or no loss of cooling fluid to other sections of the equipment mounting structure. In certain implementations, it may be that ducting or other physical containment equipment is provided and positioned to define an airtight connection between the opening and the one or more inlets (one or more being in dependence upon the number of servers mounted within the section of the equipment mounting structure to into which the opening allows cooling fluid to flow).

A valve may be a device or piece of equipment for controlling the flow of fluid through an opening. Controlling the flow of fluid may be controlling the direction or rate of fluid flow, and in relation to embodiments of the present invention should be interpreted as meaning at least controlling the rate of fluid flow through an opening. The control exerted by the valve is of course subject to certain boundary conditions such as the amount of fluid reaching the opening, for example, the amount of cooling fluid from a cooling fluid supply system reaching the opening via a cooling fluid distribution network/system or otherwise. A valve may be configurable insofar as the position or arrangement of one or more components of the valve is adjustable to increase or decrease the rate at which cooling fluid reaching the opening is allowed to pass through the opening. The valve may be, for example, a slit valve, a curtain valve, or similar devices to regulate airflow. Selectively configurable may be taken to mean that the configuration of the valve can be selected, for example, in accordance with control signals. That is to say, the valve may have a number of possible operating positions (each allowing a different cooling fluid flow rate through the opening), and the current operating position from the number of possible operating positions is selected in accordance with a control signal.

The server equipment mounting structure may be, for example, a rack such as a rack which is standardised in server technology, or may be a group of more than one racks, for example a group of racks provided within a container. Alternatively, the server equipment mounting structure may be an aisle of racks within a data centre.

Optionally, embodiments may further comprise a controller operable to receive indications of operating states of equipment mounted within a particular section of the equipment mounting structure, to generate control signals for the particular cooling fluid flow regulator coupled to the valve controlling the rate of cooling fluid flow through the opening into the particular section on the basis of the received indications, and to transmit the generated control signals to the particular cooling fluid flow regulator.

In such embodiments, each valve and cooling fluid flow regulator pair are connected to a controller dedicated to a particular section of the equipment mounting structure. Advantageously, the logic required by such a controller can be simplified so that the cost of implementing each controller is low.

Additionally, embodiments comprise a controller operable to receive indications of operating states of equipment mounted within each of a plurality of different sections of the equipment mounting structure, to generate control signals for the cooling fluid flow regulator coupled to the valve controlling the rate of cooling fluid flowing through the opening into each of the plurality of different sections on the basis of the received indications, and to transmit the control signals to the cooling fluid flow regulators.

Advantageously, in such embodiments a single controller may be provided which is configured to send control signals to each of the valves for a equipment mounting structure, or for each of the valves for a collection of more than one equipment mounting structure, for example, an entire container or data centre. Furthermore, a single controller receiving indications of operating states from more than one different section of a equipment mounting structure enables the operating states and cooling fluid flow to other sections of the equipment mounting structure to be taken into account when generating a control signal for any one particular valve.

A controller may be implemented in hardware or software, and may be a formation of logic gates arranged to generate particular control signals in response to particular indications of operating states or combinations of indications of operating states. A controller may also be a function performed by a computing device which has other, possibly complementary management functions in the data centre or container within which the equipment mounting structure is located.

In embodiments of the present invention the control signals are generated as automated responses to and in dependence upon received indications of operating states of mounted equipment within different sections of the equipment mounting structure. Thus, both the ongoing control and manipulation of valves controlling the flow of cooling fluid into the different sections of an equipment mounting structure are performed without manual intervention. Advantageously, the automation of these processes ensures consistent application of logic for determining required valve configurations based on operating states and given boundary conditions, and reduces the amount of movement of operatives within the enclosure housing the equipment mounting structures, which is desirable in terms of reducing unwanted interference with cabling and airflows.

Additionally, embodiments further comprise a cooling fluid supply system operable to supply cooling fluid to a cooling fluid distribution network by which the plurality of openings to the equipment mounting structure are in fluid communication with the cooling fluid supply system; wherein the controller is operable to control the rate at which the cooling fluid supply system is operable to supply cooling fluid, and the

temperature of the cooling fluid supplied by the cooling fluid supply system, in dependence upon the received indications of operating states of mounted equipment.

Advantageously, by controlling the temperature and/or the supply rate of the cooling fluid supply system further energy efficiency improvements can be made. For example, there may be an optimum temperature of cooling fluid which it is particularly efficient for the cooling fluid supply system to supply (which may be constant or may be dependent upon environmental or operating conditions), and the valves can be controlled in such a way that they allow the amount of cooling fluid at the optimum temperature to pass through the opening in order to dissipate the heat generated by mounted equipment in the respective sections of the equipment mounting structure. Similarly, it may be that the controller is configured to gain an overall picture of the power being dissipated by mounted equipment in the equipment mounting structure, data centre or container as a whole, and to adjust the temperature and rate of supply of cooling fluid to provide a level of cooling to match, exceed (to provide overall cooling) or fall short of (to reduce energy consumption by allowing temperature to increase within safe operating boundaries) the power being dissipated. Of course, the cooling fluid supply system may be one or more air conditioning units, and/or a supply of cooled air from another source. The cooling fluid would thus be cooled air (in embodiments where the air has heat removed by an air conditioning unit), or air.

In addition, embodiments may further comprise a workload scheduler operable to allocate tasks to the mounted equipment in dependence upon a calculated energy cost of the allocation relative to one or more other possible allocations, and to transmit to the controller data indicating the allocation.

Advantageously, embodiments of the present invention which include, or operate in cooperation with, a scheduling/allocation strategy that takes into account the energy cost of the allocation of tasks among mounted equipment will result in further reductions in heat load. For example, it may be that the calculated energy cost is a calculation of a predicted increase in heat load caused by a potential allocation from among a plurality of potential allocations. The allocation causing the smallest increase in heat load may be selected. Alternatively, it may be that the calculated energy cost is a calculation of a predicted increase in power required to remove the heat load in the system (mounting structure/container/enclosure) relative to the power required to remove the current heat load in the system for each of a plurality of potential allocations.

Optionally, embodiments may further comprise a conduit for channelling cooling fluid from an inlet in fluid communication with a cooling fluid supply, and the plurality of openings to the equipment mounting structure.

Advantageously, such a conduit provides a certain level of isolation to the cooling fluid flow paths between the cooling fluid supply and the plurality of openings. Containing the flow of cooling fluid to mounted equipment allows for better control of fluid flow in the enclosure. The conduit may be, for example, the inner wall of a container having a cooling fluid supply at one end and one or more equipment mounting structures into which equipment is mountable at the other. In exemplary embodiments, the conduit provides an airtight channel between a cooling fluid supply, or an inlet from a distribution system for distributing cooling fluid therefrom, and the openings.

In such embodiments, the conduit may form an airtight seal around an outlet in ducting through which cooling fluid from a cooling fluid supply is distributed, and forms an airtight seal around one or more of the plurality of openings to the equipment mounting structure, so that the conduit defines an airtight passage between the outlet in the ducting and the one or more of the plurality of openings.

Advantageously, the greater the isolation of the passage of cooling fluid between the cooling fluid supply and the openings from other flows of fluid, the more accurately the rate of cooling fluid being allowed to pass through an opening can be controlled by the valves in embodiments of the present invention. For example, the cooling fluid may be distributed via an underfloor ducting network having perforated tiles through which cooling fluid can flow into the enclosure in which the equipment mounting structures and mounted equipment are housed. The conduit may thus be an airtight manifold forming a seal around the perforated tile at one end, and forming a seal around one or more openings to the equipment mounting structure at the other end.

Optionally, in embodiments of the present invention, the indications of operating states are provided by one or more individual devices mounted within the section of the equipment mounting structure, and include indications of one or more of the following operating states:

flow rate of cooling fluid at the inlet to the individual device;
temperature of cooling fluid at the inlet to the individual device;
power dissipated by the individual device;
workload of the individual device; and
temperature inside the individual device.

In particular, the individual devices may be servers. In such embodiments, the controller effectively uses the servers themselves as sensors, although embodiments of the present invention include systems in which sensors, for example, temperature sensors, are provided externally to the servers. A monitoring standard such as IPMI may be used for the reporting of operating states between the servers and the controller. The precise operating states or combination of operating states reported by a server will depend on the implementation, but preferably may include an indication of current temperature and an indication of workload or power dissipation, so that the controller has enough information to derive whether or not the server is operating at a safe or efficient temperature, the temperature change required to achieve a safe or efficient operating temperature (or the change allowed whilst remaining at such a temperature), and the cooling required (flow rate and temperature of cooling fluid) to achieve that temperature change or to sustain the current desirable temperature. The reporting of operating states may be performed intermittently at a predetermined interval, in response to a request from the controller, or in response to a change in operating state of a predetermined magnitude. Alternatively, there may be certain triggers that cause operating states to be reported, for example, an operating state falling below or exceeding a predetermined threshold. The reporting mechanism and timing may be the same for each operating state or may be different, depending on the particular implementation.

Optionally, the sections of the equipment mounting structure into which the openings allow fluid to flow are sections dimensioned to receive a single server device.

Advantageously, such embodiments enable the flow of cooling fluid for every server mounted on the server equipment mounting structure to be individually controlled. Improvements in efficiency can be gained by ensuring that cooling fluid is only supplied to servers which require it, and performance improvements can be achieved by controlling temperatures of servers so that they operate at or around their optimum operating temperatures.

Embodiments may further comprise, for each of the plurality of openings to the equipment mounting structure, a sleeve configured to form an airtight connection between the opening and the cooling fluid inlet of the equipment mounted within the section into which the opening allows cooling fluid to flow.

Depending on the arrangement of the equipment within the equipment mounting structure, it may be that an advantage can be gained by providing a sleeve to maximise the proportion of the air passing through the opening that flows into a server mounted within the section of the structure to which the opening allows cooling fluid to flow.

According to embodiments of another aspect of the present invention, there is provided a system comprising: an equipment mounting structure divided into sections into which equipment can be mounted; and apparatus for regulating the flow of cooling fluid to equipment mounted in an equipment mounting structure embodying the present invention. Such a system may be a system comprising: a server equipment mounting structure divided into sections into which server equipment can be mounted; and apparatus for regulating the flow of cooling fluid to server equipment mounted in the server equipment mounting structure embodying the present invention.

According to embodiments of another aspect of the present invention, there is provided a controller for controlling apparatus for regulating the flow of cooling fluid to equipment mounted in an equipment mounting structure, the apparatus comprising, for each of a plurality of openings to the equipment mounting structure, each opening allowing cooling fluid to flow into a different section of the equipment mounting structure and in fluid communication with a cooling fluid inlet of equipment when said equipment is mounted within that section: a valve selectively configurable to control the rate of cooling fluid flowing through the respective opening; and a cooling fluid flow regulator coupled to the valve and operable to configure the coupled valve in accordance with received control signals generated in dependence upon indications of operating states of equipment mounted within the section into which the opening allows cooling fluid to flow; wherein the controller is operable to receive indications of operating states of equipment mounted within each of a plurality of different sections of the equipment mounting structure, to generate control signals for the cooling fluid flow regulator coupled to the valve controlling the rate of cooling fluid flowing through the opening into each of the plurality of different sections on the basis of the received indications, and to transmit the control signals to the cooling fluid flow regulators.

A controller embodying the present invention may be a controller for controlling apparatus for regulating the flow of cooling fluid to server equipment mounted in a server equipment mounting structure, the apparatus comprising, for each of a plurality of openings to the server equipment mounting structure, each opening allowing cooling fluid to flow into a different section of the server equipment mounting structure and in fluid communication with a cooling fluid inlet of server equipment when said server equipment is mounted within that section: a valve selectively configurable to control the rate of cooling fluid flowing through the respective opening; and a cooling fluid flow regulator coupled to the valve and operable to configure the coupled valve in accordance with received control signals generated in dependence upon indications of operating states of server equipment mounted within the section into which the opening allows cooling fluid to flow; and a cooling fluid supply system operable to supply cooling fluid to a cooling fluid distribution network by which the plurality of openings to the equipment mounting structure are in fluid communication with the cooling fluid supply system; wherein the controller is operable to receive indications of

operating states of server equipment mounted within each of a plurality of different sections of the server equipment mounting structure, to generate control signals for each of the cooling fluid flow regulators coupled to the valves controlling the rate of cooling fluid flowing through the opening into each of the plurality of different sections on the basis of the received indications, and to transmit the control signals to the cooling fluid flow regulators; and wherein the controller is operable to control the rate at which the cooling fluid supply system is operable to supply cooling fluid, and the temperature of the cooling fluid supplied by the cooling fluid supply system, in dependence upon the received indications of operating states of mounted equipment.

Embodiments of another aspect of the present invention include a computer program, which, when executed by a computing device, causes the computing device to function as a controller embodying the present invention.

According to embodiments of another aspect of the present invention, there is provided a method for controlling apparatus for regulating the flow of cooling fluid to equipment mounted in an equipment mounting structure, the apparatus comprising, for each of a plurality of openings to the equipment mounting structure, each opening allowing cooling fluid to flow into a different section of the equipment mounting structure and in fluid communication with a cooling fluid inlet of equipment when said equipment is mounted within that section: a valve selectively configurable to control the rate of cooling fluid flowing through the respective opening; and a cooling fluid flow regulator coupled to the valve and operable to configure the coupled valve in accordance with received control signals generated in dependence upon indications of operating states of equipment mounted within the section into which the opening allows cooling fluid to flow;

and a cooling fluid supply system operable to supply cooling fluid to a cooling fluid distribution network by which the plurality of openings to the equipment mounting structure are in fluid communication with the cooling fluid supply system;

wherein the method comprises: receiving indications of operating states of equipment mounted within each of a plurality of different sections of the equipment mounting structure; generating control signals for the cooling fluid flow regulator coupled to the valve controlling the rate of cooling fluid flowing through the opening into each of the plurality of different sections on the basis of the received indications; and transmitting the control signals to the cooling fluid flow regulators; and controlling the rate at which the cooling fluid supply system is operable to supply cooling fluid, and the temperature of the cooling fluid supplied by the cooling fluid supply system, in dependence upon the received indications of operating states of mounted equipment.

Such a method may be a method for controlling apparatus for regulating the flow of cooling fluid to server equipment mounted in a server equipment mounting structure, the apparatus comprising, for each of a plurality of openings to the server equipment mounting structure, each opening allowing cooling fluid to flow into a different section of the server equipment mounting structure and in fluid communication with a cooling fluid inlet of server equipment when said server equipment is mounted within that section: a valve selectively configurable to control the rate of cooling fluid flowing through the respective opening; and a cooling fluid flow regulator coupled to the valve and operable to configure the coupled valve in accordance with received control signals generated in dependence upon indications of operating states of server equipment mounted within the section into which the opening allows cooling fluid to flow; wherein the method comprises: receiving indications of operating states of server equipment mounted within each of a plurality of different sections of the server equipment mounting structure; generating control signals for each of the plurality of different sections of the server equipment mounting structure on the basis of the received indications; and transmitting the control signals to the cooling fluid flow regulators.

Embodiments of another aspect of the present invention include a computer program which, when executed by a computing device, causes the computing device to perform a method embodying the present invention.

A detailed description of some embodiments of the present invention will now be provided, purely by way of example, with reference to the accompanying drawings in which:

Figure 1 illustrates a first embodiment of the present invention;
Figure 2 illustrates a second embodiment of the present invention;
Figure 3 is a pictorial representation of another embodiment of the present invention;
Figure 4 illustrates in detail an example of how a server may be connected to an opening in a particular section of a rack in embodiments of the present invention;
Figure 5 is a pictorial representation of another embodiment of the present invention;
Figure 6 illustrates a flow of control in a controller, method, or program embodying the present invention;
Figure 7 illustrates an embodiment which includes an energy-aware workload scheduler.

Figure 1 is a schematic diagram illustrating a first embodiment of the present invention. Figure 1 illustrates an embodiment in which the server equipment mounting structure 10 has two different sections, each housing server equipment 20 having a cooling fluid inlet 21. Each of the plurality of sections of the server equipment mounting structure has an opening allowing cooling fluid to flow into that section. The each of the plurality of openings are in fluid communication with the inlets 21 of the server equipment mounted within the section of the server equipment mounting structure to which the opening allows cooling fluid to flow. For example, in the illustration of Figure 1 the proximity of the inlet 21 to the opening establishes a fluid communication between the two. Within each opening a valve 30 is positioned in order to control the flow of cooling fluid through the opening. The valves 30 are selectively configurable to control the rate of cooling fluid flowing through the opening. In the embodiment pictured in Figure 1, the valve is configurable by means of changing the angle at which a slit valve sits within a slit opening. Different angles allow different flow rates of cooling fluid through the opening. The selection of configuration of the valve 30 is made by a coupled cooling fluid flow regulator 31 in accordance with received control signals. The server equipments 20, which may be servers, are operable to report indications of operating states to a controller or control system, in response to which control signals are generated and transmitted to the cooling fluid flow regulators 31. The dashed lines in Figure 1 represent the flow of data out of the server equipment 20 and into the cooling fluid flow regulators 31. It may be that the data are transmitted via a cabling system, or it may be that a wireless data transmission system is employed. Alternatively, a combination of cables and wireless data transmission could be used in embodiments of the present invention. It may be that a control signal is transmitted to a particular cooling fluid flow regulator 31 in response to indications of operating states of server equipment 20 within the section of the server equipment mounting structure 10 having the opening through which the valve coupled to the particular cooling fluid flow regulator 31 controls the flow rate. Alternatively or additionally, the control signal may be transmitted to a particular cooling fluid flow regulator 31 in response to indications of operating states of server equipment with other sections of the server equipment mounting structure 10.

Figure 2 shows a second embodiment of the present invention. In the embodiment illustrated in Figure 2, a rack 10 is divided into sections by shelf panels 11. The rack is an example of a server equipment mounting structure mentioned elsewhere in this document. Each of the different sections houses a server 20. The servers 20 are examples of the server equipment mentioned elsewhere in this document. The rack 10 has an opening at a front side of each section, allowing air to flow into that section. An airtight manifold 40 is attached to the front side of the rack by forming a seal 41 around each of the openings. The airtight manifold 40 is an example of the conduit mentioned elsewhere in this document. The manifold has a number of outlets 41, in the form of seals formed so that the outlet of the manifold is coincident with a corresponding opening in the rack 10 and hence the outlet 41 and the corresponding opening are in airtight fluid communication with one another. Each opening is in fluid communication with an inlet in the server 20 housed within the section to which that opening allows air to flow, the inlet allowing air to flow into the server 20 to transfer heat away from the hardware components therein. In this embodiment, air, specifically cooled air, is exemplary of the cooling fluid mentioned elsewhere in this document. The fluid communication may be airtight fluid communication, for example, if there is a member forming a duct between the opening and the inlet. The top and bottom panels of each rack shelf 11 may be made from an impermeable material so that each section acts like a duct containing the air that is injected through it. The rear side (the side opposing the side in which the openings are defined) of the rack 10 is open, providing space for the required cabling and allowing exhaust of air from the servers 20 into a hot aisle. The manifold forms an airtight passage, conduit, or duct for air from a cold air supply, for example, air from an air conditioning system distributed via a network of ducts having an outlet at which air enters an inlet 42 of the manifold 40, and is hence provided to the servers 20 through the manifold outlets 41 and openings in the rack 10.

Each manifold outlet 41 is fitted with a valve 30 having an associated cooling fluid flow regulator 31 (not pictured) whose combined purpose is to regulate the supply of cool air entering each section of the rack 10 and hence each server 20. Each valve is selectively configurable to allow different rates of air into the corresponding opening (given a particular rate of air supplied to the valve or air pressure at the incoming side) in accordance with control signals received from a control system 50. The valve configurations may be physically set via actuators (not shown in the drawing) governed by an automatic control system 50 via a cooling fluid flow regulator 31 associated with each valve 30 (and possibly also actuator where provided). The control system 50 is exemplary of controllers mentioned elsewhere in this document, and uses information about server temperatures, airflows. and dissipated power at each server to determine the rate of cool air flow required to remove each server's heat load, and the necessary valve configurations to achieve that required cool air flow. The control system 50 is configured to send control signals to the cooling fluid flow regulators 31 to set the valves 30 to the necessary configurations or opening values. The information about server temperatures, airflows, and dissipated powers is exemplary of the indications of operating states of server equipment mentioned elsewhere in this document. In addition, the control system 50 may be operable to use the received information to set the temperature and rate of supply of air by an air conditioning 60 in order that rate and cooling potential of air arriving at the valves 30 can be controlled. In this way the use of cooling resources is optimised since the air conditioning system supplies only the required cooling power, without the waste of energy associated to recirculation, bypass or overdimensioning of the cooling system. The air conditioning system 60 is exemplary of the air supply systems mentioned elsewhere in this document. The air conditioning system 60 is in fluid communication with an inlet 42 to the manifold 40, for example via ducting such as underfloor ducting.

In Figure 2, airflow is illustrated by curved arrows. The curved arrows are not intended to trace actual airflow paths but are merely representative of which apparatus the air flows through in the illustrated embodiment. The dotted arrows marked "cold air supply" illustrate the cold air supplied by the air conditioning system 60 and entering the airtight manifold 40 via the inlet 42. Hence, there is cold air being supplied to each manifold outlet 41. The amount of cold air allowed to pass out of each outlet 41 and hence through the corresponding opening into a section of the rack 10 is controlled by the valve 30 at that outlet 41 in accordance with control signals from the control system 50. The curved arrows within the servers 20 represent cold air having been supplied to a manifold outlet 41 and allowed through the valve 30, into the section of the rack 10 in which the server 20 is mounted and into the inlet of that server. The different lengths of curved arrows within the servers is intended to illustrate different rates of airflow through the servers 20. The shorter arrows represent a lower flow rate, and the longer arrows represent a higher flow rate. The air leaves the servers 20 via an outlet at the opposite side of the rack from the openings into which the cold air flows. Heat exchange with the components of the servers 20 results in the air being heated during its passage through the server 20 and the air exhausted being "hot" in relation to the supplied air entering the server.

Servers are added or removed from the rear of the rack, so that the valves 30 and their associated cooling fluid flow regulators 31 and actuators where provided are not disturbed by the addition or removal of server equipment. Similarly, cables are accessible at the rear of the rack, so that cables may be inserted, removed, or reconfigured without disturbing the valves 30 and their associated apparatus.

Figure 3 is a pictorial representation of another embodiment of the present invention. The rack 10 is as the rack described in the previous embodiment, comprising a plurality of sections each housing a server 20 being separated by shelf panels 11 and having an opening to each section at a front side of the rack 10. A hermetic enclosure 70, as an example of the conduit described elsewhere in this document, and being a particular form of the generic manifold 30 described in the previous embodiment, is removably attachable (can be removed and reattached during the course of normal use without causing permanent deformation or requiring equipment peculiar to the particular purpose) to the side of the rack 10 having the openings into which air is allowed to flow to the different sections of the rack 10. For illustrative purposes, the hermetic enclosure 70 itself is drawn as transparent in Figure 3 with its edges marked by a dashed line, in order that the front side of the rack 10 is visible. The hermetic enclosure 70 has a number of openings which serve as outlets to allow air to flow out of the hermetic enclosure 70 and into the openings in the rack 10. Each outlet in the hermetic enclosure corresponds to an opening in the rack 10, and forms a hermetic seal around the corresponding opening. The hermetic enclosure 70 also has an inlet into which air flows from a perforated tile 81 in a raised floor air ducting/distribution system 80. When attached to the rack 10 and appropriately positioned on the raised floor 80, the hermetic enclosure 70 forms a hermetic seal around the perforated tile 81 through which air flows into the hermetic enclosure 70, for example, air from an air conditioning system 60 or other air supply system. The arrangement of valves 30 within openings and the configuration and control of said valves is consistent with that of the previous embodiment. The hermetic enclosure 70 is a particular means for channelling air (as an example of a cooling fluid) from an air supply system, or distribution system in fluid communication with an air supply system, to the openings in the rack 10. Of course, the hermetic nature of the enclosure makes airflow in the enclosure more predictable and hence enables a greater degree of control over the flow of air into the different sections of the rack, thus enabling efficient cooling of the servers 20.

Figure 4 illustrates in more detail an example of how a server 20 may be connected to an opening in a particular section of the rack 10 in embodiments of the present invention. For example, a connection such as that illustrated in Figure 4 could be employed in the embodiments illustrated in Figures 2 and 3.

In the example of Figure 4, the rack frame 10 is fitted with impermeable shelf panels 11 defining a top side and bottom side of the section of the rack 10, hence the section effectively defines a duct between an opening at a front side and an exhaust at a rear side. A server 20 is mounted within the section. An inlet of the server 20 faces the opening through which air flows into the section. The opening is defined by lips (protruding inwardly relative to a front side of the rack) about which an airtight sleeve 12 is fitted, with the other end of the sleeve receiving the server 20 or in some other way arranged to form an airtight seal around the air inlet of the server 20. The sleeve 12 is exemplary of a member forming a duct between the opening and the inlet mentioned elsewhere in this document. In this particular example, the valve 30 is a slit valve, and a valve actuator 31 provides the functionality of a cooling fluid flow regulator mentioned elsewhere in this documents, hence receives control signals and physically manipulates the position of the slit valve 30 in accordance with the received control signals. An emergency pin 32 is provided to allow an operator to manually manipulate the position of the slit valve 30 in the event of a malfunction of the valve actuator 31 or associated controller. The sleeve may be made from silicone, rubber, or other similar impermeable material providing an airtight passage.

In operation, air flows into the opening at a rate controlled by the position of the slit valve 30 within the opening. The air then flows into the inlet of the server 20 via the airtight sleeve 12. The incoming air is cool relative to certain of the hardware components within the server 20, hence heat exchange takes place during the passage of air through the server 20 and the air is exhausted from an exhaust outlet at a higher temperature than that at which it flowed into the server 20. Of course, airflow in embodiments may be facilitated or aided by the provision of fans and equivalent components both within servers, within air conditioning units, in ducts, and/or in other positions in the enclosure at which the flow of air may be affected. Should the server experience an increase in workload, then such an increase may be reported to a controller. In response to that indication, and in anticipation of an increase in temperature within the server, the controller may generate and transmit a control signal to the valve actuator 31 to specify an absolute or relative valve configuration (for example, open by a single increment, or open to 70% open). The precise nature of the signalling will depend on the particular implementation. The valve actuator 31 is then configured to alter the configuration of the valve 30, should any alteration be required, in accordance with the received control signal. Thereby, a change in the configuration of the valve 30 is realised, and the amount of air flowing into the opening and hence into the inlet of the server 20 is increased and the amount of heat removed from the server 20 increased. Of course, the reporting may not necessarily be of a change in workload, or even related to workload at all, it could alternatively or additionally report indications of other operating states such as temperature of particular components within the server, a general indication of air temperature in the server, current airflow rate through the server, and other operating states which will be dependent upon the particular implementation.

Figure 5 is a pictorial illustration of another embodiment of the present invention. A plurality of racks 10, in this case three, are placed inside a container data centre 90 with their front sides having the openings into which air is allowed to flow facing an air conditioning unit 60 injecting cold air into the container 90. The air injected into the container 90 by the air conditioning unit 60 flows into the servers via a configuration of apparatus such as that depicted in Figures 1 and/or 4. The principal differences between the embodiments of Figures 2, 3, and 5, are the nature of the conduit by which air reaches the openings, and possibly also the air supply and distribution systems. However, it will be appreciated by the skilled person that the embodiments have many features in common, and hence much of the discussion should be interpreted as relevant to all of the embodiments, rather than any one embodiment in particular.

In the embodiment of Figure 5, the walls of the container define a conduit for containing the flow of air between an air supply system - the air conditioning unit 60 - and the openings in the racks 10. A control system (not shown) is operable to receive indications of operating states of the servers housed within the racks 10, and to generate and transmit control signals to the regulators coupled to the valves 30 in the openings, and to control the setpoint and fan speeds in the air conditioning unit 60 in order to provide adequate cooling of servers while minimising energy consumption.

Figure 6 illustrates a flow of control in a controller embodying the present invention. At steps S101 and S102 the control system simply monitors the on/off state of all server devices in the rack; if a given server device is turned off then the valve controlling the airflow into the section of the rack in which that server is mounted is closed at step 103 - based on an assumption of one server device per section. If there is more than one server device in any particular section then the valve will not be closed unless all of the server devices in that section are turned off. If a server device is turned on, the flow proceeds to step S104 and the controller monitors its temperature, dissipated power, and incoming airflow rate. In exemplary embodiments, the monitoring function can be performed by reporting in accordance with an implementation of IPMI (Intelligent Platform Monitoring Interface) and/or through a suitable management system such as one in accordance with the embodiments described in European patent application number 11194408.8, to which reference may be made.

The flow then continues to step S105, where the system verifies if the temperature within each server device, or at a particular hardware component thereof, is within predefined acceptable limits; if this is the case the monitoring continues at step S104. However, if the temperature of any server device or of any individual hardware component of a server device is outside of the acceptable limits (i.e. above a maximum acceptable operating temperature) then the controller uses an algorithm to determine the minimum required airflow rate and the maximum acceptable airflow temperature required to bring the temperature of the equipment into its normal operating range (within an amount of time which may be dependent upon the extent to which the acceptable limit is exceeded and/or the identity/type of the hardware component or server device) is calculated at step S106. This calculation can be based on a physical model of the device or can be derived from a suitable simulation: its aim is to find the combination of airflow rate and temperature that will bring the temperature of the device within the desired range with a minimum energy expense. Alternatively, it may be that the airflow to the device is simply increased incrementally and/or the temperature of air supplied to the device is decreased incrementally until the monitoring reveals that the temperature within the device or component is decreasing.

Once such calculations have been performed for all devices or components operating outside of their acceptable temperature range, the flow proceeds to step S107 in which the controller determines a global airflow rate and temperature setting for the air supply system at step S107. Global in this sense depends on the implementation, and it may be that it is a particular rack or group of racks for which airflow rate and temperature are determined. Alternatively, it may that the air temperature has to be determined in conjunction with controllers of other racks (since they have a common air supply), but that the air distribution system among the racks is such that each controller can determine an individual airflow rate for its rack. One possible, simple, way of determining global airflow rate and temperature at step S107 is as follows: let $f_1$, $f_2$,...,$f_N$ be the minimum required airflow rates for each of the N devices in a rack, and let $T_1$, $T_2$,...,$T_N$ be the maximum airflow temperatures required by each device. The global airflow rate and temperature setting $f_G$ and $T_G$ are then:

$$f_G = \sum_{t=1}^{N} f_t \text{ and } T_G = \min\{T_1, T_2, ..., T_N\}$$

The flow then proceeds to step S108, where the control system calculates the valve opening settings for the openings allowing air to flow into the rack section in which each and every active device in the rack is mounted in order to allow entry of the necessary amount of airflow. These settings may correspond to the values $f_1$, $f_2$,...,$f_N$ determined at step S106, or alternatively, the values $f_1$, $f_2$,...,$f_N$ may be modified (i.e. decreased) to compensate for a temperature of air supply that is colder than required by the device within the section to which the opening allows air to flow. The control system then signals the cooling fluid flow regulators to set the valve openings at step S109, and changes the settings of the cooling system to the determined global airflow rate and temperature values $f_G$ and $T_G$ at step S110. The flow then goes back to step S104, where the monitoring of each device's temperature, dissipated power, and incoming airflow continues.

Figure 7 illustrates an embodiment which includes an energy-aware workload scheduler. The arrangement of the rack, the server equipment mounted thereon, and its interaction with the control system and the supply is illustrated in accordance with the embodiment of Figure 2, but could be in accordance with any embodiment of the present invention. The purpose of the embodiment illustrated in Figure 6 is to demonstrate an extension to the other embodiments achieved by providing a scheduler 55.

The potential for energy savings can be maximized if the embodiments of the present invention include or are used in cooperation with a workload scheduler 55 configured to perform workload consolidation and job scheduling/queuing based on energy costs; in this way hardware utilization would be optimized with the consequent reduction in the use of cooling resources. Even slight reductions in heat load can result in significant energy savings by delivering only the required amount of cooled air to the racks; further reductions in heat load are achievable by virtualization and an appropriate scheduling/allocation strategy. Figure 7 shows a possible embodiment illustrating this idea: a workload scheduler 55 or batch job executer distributes workload among the servers according to an energy cost measure (of which there are many possible workload cost measures that can be employed); the scheduler communicates with the control system 50 which in turn adjusts the setpoint of the cooling system 60 and the airflow rates into each device in the rack using information about their temperatures and dissipated powers. In this way, workload is allocated in a way that minimises energy consumption through workload consolidation and parsimonious use of cooling resources. Workload may be discrete tasks that arrive at the scheduler via a network or some other means and must be allocated to a particular device mounted on the mounting structure. The scheduler 55 is operable to select one from a plurality of potential devices to perform the task by performing energy cost calculations and selecting, for example, the allocation causing the lowest energy cost, or the first potential device for which the calculated energy cost is under a threshold. The energy cost may be calculated by predicting the increase in heat load caused by the allocation. Alternatively, it may be that the calculated energy cost is a calculation of a predicted increase in power required to remove the heat load in the system (mounting structure/container/enclosure) relative to the power required to remove the current heat load in the system for each of a plurality of potential allocations.

A first order estimate of the energy savings that can be achieved with embodiments of the present invention can be obtained by assuming that fans used to deliver cool air to the equipment in the equipment mounting structure obey a cubic law (a common practice in data centre modeling and simulation):

$$P = P_{max}\left(\frac{f}{f_{max}}\right)^3$$

where Pmax is the power consumed when the fan delivers its maximum airflow rate fmax, and f is the airflow rate required by the equipment in the equipment mounting structure at a given time. Now if a fraction F of the equipment in the equipment mounting structure is turned off, the required airflow rate will be reduced by 1 - F, and the power consumed by the fans will be:

$$P = P_{max}(1 - F)^3$$

Therefore, an estimate for the energy savings S (%) that can be achieved by delivering just the required airflow rate to the equipment mounting structure is:

$$S = (1 - (1 - F)^3) \times 100\ (\%)$$

Table 1 shows estimates for the energy savings that can be achieved for several values of F : the non-linear nature of the fans makes energy savings significant even for small reductions in airflow rate. For instance, if half of the equipment in the rack can be turned off, and cooling fluid delivery to the sections housing the turned off equipment be suspended, energy savings of up to 87% can be achieved in principle.

Table 1: Energy savings estimates

| Unused equipment fraction *F* | Energy savings (%) |
|---|---|
| 0.125 | 33 |
| 0.25 | 57.8 |
| 0.375 | 75.6 |
| 0.5 | 87.5 |
| 0.625 | 94.7 |
| 0.75 | 98.4 |
| 0.875 | 99.8 |

As mentioned above, the potential for energy savings can be maximized if invention embodiments are used in conjunction with workload consolidation and job scheduling/queuing based on energy costs; in this way hardware utilization is optimized with the consequent reduction in the use of cooling resources.

It should be appreciated that features and attributes of one embodiment or aspect of the present invention may be applied to or combined with features and attributes of other embodiments or aspects. For example, where features are described as method steps, it should be appreciated that invention embodiments include apparatus configured to perform those methods. Where invention embodiments include apparatus performing particular functionality, it is implicitly disclosed that the apparatus is configured/adapted/operable to perform that functionality, and furthermore that invention embodiments include a method of performing that functionality.

In any of the above aspects, the various features may be implemented in hardware, or as software modules running on one or more processors. Features of one aspect may be applied to any of the other aspects. That is to say, where a feature is attributed to an apparatus, invention embodiments also include a method for performing the function provided by said apparatus, and vice versa.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

## Claims

1. Apparatus for regulating the flow of cooling fluid to equipment (20) mounted in an equipment mounting structure (10), the apparatus comprising, for each of a plurality of openings to the equipment mounting structure, each opening allowing cooling fluid to flow into a different section of the equipment mounting structure and in fluid communication with a cooling fluid inlet (21) of equipment when said equipment is mounted within that section:

   a valve (30) selectively configurable to control the rate of cooling fluid flowing through the opening; and
   a cooling fluid flow regulator (31) coupled to the valve (30) and operable to configure the coupled valve (30) in accordance with received control signals generated in dependence upon indications of operating states of equipment mounted within the section into which the opening allows cooling fluid to flow;
a controller (50) operable to receive indications of operating states of equipment (20) mounted within each of a plurality of different sections (11) of the equipment mounting structure (10), to generate control signals for the cooling fluid flow regulator (31) coupled to the valve (30) controlling the rate of cooling fluid flowing through the opening into each of the plurality of different sections (11) on the basis of the received indications, and to transmit the control signals to the cooling fluid flow regulators (31);
a cooling fluid supply system (60) operable to supply cooling fluid to a cooling fluid distribution network by which the plurality of openings to the equipment mounting structure are in fluid communication with the cooling fluid supply system;

wherein the controller is operable to control the rate at which the cooling fluid supply system is operable to supply cooling fluid, and the temperature of the cooling fluid supplied by the cooling fluid supply system (60), in dependence upon the received indications of operating states of mounted equipment.

**2.** The apparatus according to claim 1, further comprising:

a workload scheduler operable to allocate tasks to the mounted equipment in dependence upon a calculated energy cost of the allocation relative to one or more other possible allocations, and to transmit to the controller data indicating the allocation; wherein

the calculated energy cost is either a predicted increase in heat load or a predicted increase in power required to remove a predicted increase in heat load from the enclosure.

**3.** The apparatus according to any of the preceding claims, further comprising:

a conduit (40) for channelling cooling fluid from an inlet (42) in fluid communication with a cooling fluid supply (60), and the plurality of openings (41) to the equipment mounting structure.

**4.** The apparatus according to claim 3, wherein the conduit forms an airtight seal around an outlet in ducting through which cooling fluid from a cooling fluid supply is distributed, and forms an airtight seal around one or more of the plurality of openings to the equipment mounting structure, so that the conduit defines an airtight passage between the outlet in the ducting and the one or more of the plurality of openings.

**5.** The apparatus according to any of the preceding claims, wherein
the indications of operating states are provided by one or more individual devices mounted within the section of the equipment mounting structure, and include indications of one or more of the following operating states:

flow rate of cooling fluid at the inlet to the individual device;
temperature of cooling fluid at the inlet to the individual device;
power dissipated by the individual device;
workload of the individual device; and
temperature inside the individual device.

**6.** The apparatus according to any of the preceding claims, wherein
the sections of the equipment mounting structure into which the openings allow fluid to flow are sections dimensioned to receive a single server device.

**7.** The apparatus according to any of the preceding claims, further comprising, for each of the plurality of openings to the equipment mounting structure:

a sleeve (12) configured to form an airtight connection between the opening and the cooling fluid inlet of the equipment (20) mounted within the section (11) into which the opening allows cooling fluid to flow.

**8.** A system comprising:

an equipment mounting structure divided into sections into which equipment can be mounted; and
apparatus for regulating the flow of cooling fluid to equipment mounted in the equipment mounting structure according to any of claims 1 to 7.

**9.** A controller (50) for controlling apparatus for regulating the flow of cooling fluid to equipment (20) mounted in an equipment mounting structure (10), the apparatus comprising, for each of a plurality of openings to the equipment mounting structure (10), each opening allowing cooling fluid to flow into a different section (11) of the equipment mounting structure (10) and in fluid communication with a cooling fluid inlet (21) of equipment (20) when said equipment is mounted within that section

a valve (30) selectively configurable to control the rate of cooling fluid flowing through the respective opening;
a cooling fluid flow regulator (31) coupled to the valve (30) and operable to configure the coupled valve in accordance with received control signals generated in dependence upon indications of operating states of equipment (20) mounted within the section (11) into which the opening allows cooling fluid to flows

and a cooling fluid supply system operable to supply cooling fluid to a cooling fluid distribution network by which the plurality of openings to the equipment mounting structure are in fluid communication with the cooling fluid supply system;
wherein the controller (50) is operable to receive indications of operating states of equipment (20) mounted within each of a plurality of different sections (11) of the equipment mounting structure (10), to generate control signals for the cooling fluid flow regulator (31) coupled to the valve (30) controlling the rate of cooling fluid flowing through the opening into each of the plurality of different sections (11) on the basis of the received indications, and to transmit the control signals to the cooling fluid flow regulators (31);
and wherein the controller (50) is operable to control the rate at which the cooling fluid supply system is operable to supply cooling fluid, and the temperature of the cooling fluid supplied by the cooling fluid supply system, in dependence upon the received indications of operating states of mounted equipment (20).

**10.** A method for controlling apparatus for regulating the flow of cooling fluid to equipment (20) mounted in an equipment mounting structure (10), the apparatus comprising, for each of a plurality of openings to the equipment mounting structure (10), each opening allowing cooling fluid to flow into a different section (11) of the equipment mounting structure (10) and in fluid communication with a cooling fluid inlet (21)of equipment (20) when said equipment is mounted within that section:

a valve (30) selectively configurable to control the rate of cooling fluid flowing through the respective opening;
a cooling fluid flow regulator (31) coupled to the valve (30) and operable to configure the coupled valve (30) in accordance with received control signals generated in dependence upon indications of operating states of equipment (20) mounted within the section into which the opening allows cooling fluid to flows;

and a cooling fluid supply system operable to supply cooling fluid to a cooling fluid distribution network by which the plurality of openings to the equipment mounting structure are in fluid communication with the cooling fluid supply system;
wherein the method comprises:

receiving indications of operating states of equipment (20) mounted within each of a plurality of different sections (11) of the equipment mounting structure (10);
generating control signals for the cooling fluid flow regulator (31) coupled to the valve (30) controlling the rate of cooling fluid flowing through the opening into each of the plurality of different sections (11) on the basis of the received indications;
transmitting the control signals to the cooling fluid flow regulators (31); and
controlling the rate at which the cooling fluid supply system is operable to supply cooling fluid, and the temperature of the cooling fluid supplied by the cooling fluid supply system, in dependence upon the received indications of operating states of mounted equipment (20).

**11.** A computer program, which, when executed by a computing device, causes the computing device to function as a controller according to claim 9.

**12.** A computer program which, when executed by a computing device, causes the computing device to perform a method according to claim 10.

**Patentansprüche**

**1.** Vorrichtung zur Regulierung des Stroms von Kühlflüssigkeit zu einer Vorrichtung (20), die in einer Ausrüstungsmontagestruktur (10) montiert ist, wobei die Vorrichtung für jede einer Vielzahl von Öffnungen zu der Ausrüstungsmontagestruktur Folgendes umfasst, wobei Kühlflüssigkeit durch jede Öffnung in einen unterschiedlichen Abschnitt der Ausrüstungsmontagestruktur strömen kann und in Fluidverbindung mit einem Kühlflüssigkeitseinlass (21) der Vorrichtung steht, wenn die Vorrichtung innerhalb des Abschnitts montiert ist:

ein Ventil (30), das wahlweise konfigurierbar ist, um den Durchsatz der durch die Öffnung strömenden Kühlflüssigkeit zu steuern; und
einen Durchflussregler (31) der Kühlflüssigkeit, der mit dem Ventil (30) gekoppelt ist und der betreibbar ist, um das gekoppelte Ventil (30) gemäß den empfangenen Steuersignalen zu konfigurieren, welche in Abhängigkeit von Anzeigen von Betriebszuständen von Vorrichtungen, die innerhalb des Abschnitts erzeugt werden, in welchen die Kühlflüssigkeit durch die Öffnung strömen kann;
einen Controller (50), der betreibbar ist, um Anzeigen von Betriebszuständen von Vorrichtungen (20), die innerhalb von jedem aus einer Vielzahl von unterschiedlichen Abschnitten (11) der Ausrüstungsmontagestruktur (10) montiert sind, zu empfangen, um Steuersignale für den Durchflussregler (31) der Kühlflüssigkeit zu erzeugen, welcher mit dem Ventil (30) gekoppelt ist, welches den Durchsatz der Kühlflüssigkeit, die durch die Öffnung in jeden der Vielzahl verschiedener Abschnitte (11) strömt, aufgrund der empfangenen Anzeigen steuert, und Um die Steuersignale an die Durchflussregler (31) der Kühlflüssigkeit zu übertragen;
ein Kühlflüssigkeitsversorgungssystem (60), das betreibbar ist, um ein Kühlflüssigkeits-Verteilungsnetz, durch das die Vielzahl von Öffnungen zu der Ausrüstungsmontagestruktur in Fluidverbindung mit dem Kühlflüssigkeitsversorgungssystem ist, zu versorgen;

wobei der Controller betreibbar ist, um den Durchsatz, mit dem das Kühlflüssigkeitsversorgungssystem betreibbar ist, um Kühlflüssigkeit zuzuführen, und die Temperatur der Kühlflüssigkeit, die von dem Kühlflüssigkeitsversorgungssystem (60) zugeführt wird, in Abhängigkeit von den empfangenen Anzeigen von Betriebszuständen der montierten Vorrichtungen zu steuern.

**2.** Vorrichtung nach Anspruch 1, ferner umfassend:

einen Workload Scheduler, der betreibbar ist, um Aufgaben an die montierte Ausrüstung in Abhängigkeit von berechneten Energiekosten der Zuweisung in Bezug auf eine oder mehrere andere mögliche Zuweisungen zuzuweisen und Daten zur Angabe der Zuweisung an den Controller zu übertragen; wobei

die berechneten Energiekosten entweder eine vorhergesagte Zunahme der Wärmelast oder eine vorhergesagte Zunahme der Leistung, die zur Beseitigung einer vorhergesagten Zunahme der Wärmelast aus dem Gehäuse erforderlich ist, ist.

**3.** Vorrichtung nach einem der vorhergehenden Ansprüche, ferner umfassend:

eine Leitung (40) zur Leitung von Kühlflüssigkeit von einem Einlass (42), der in Fluidverbindung mit einer Kühlflüssigkeitsversorgung (60) steht, und der Vielzahl von Öffnungen (41) zu der Ausrüstungsmontagestruktur.

**4.** Vorrichtung nach Anspruch 3, wobei die Leitung eine luftdichte Dichtung um einen Auslass in der Leitung herum bildet, durch welche Kühlflüssigkeit aus einer Kühlflüssigkeitsversorgung verteilt wird, und eine luftdichte Dichtung um eine oder mehrere der Vielzahl von Öffnungen zu der Ausrüstungsmontagestruktur bildet, sodass die Leitung einen luftdichten Durchlass zwischen dem Auslass in der Leitung und der einen oder mehreren aus der Vielzahl von Öffnungen definiert.

**5.** Vorrichtung nach einem der vorhergehenden Ansprüche, wobei
die Anzeigen von Betriebszuständen von einer oder mehreren einzelnen Vorrichtungen, die innerhalb des Abschnitts der Ausrüstungsmontagestruktur montiert sind, bereitgestellt werden und Anzeigen von einem oder mehreren der folgenden Betriebszustände umfassen:

Durchsatz der Kühlflüssigkeit am Einlass zu der einzelnen Vorrichtung;
Temperatur der Kühlflüssigkeit am Einlass zu der einzelnen Vorrichtung;
Verlustleistung der einzelnen Vorrichtung;
Auslastung der einzelnen Vorrichtung; und
Temperatur innerhalb der einzelnen Vorrichtung.

**6.** Vorrichtung nach einem der vorhergehenden Ansprüche, wobei
die Abschnitte der Ausrüstungsmontagestruktur, in welche Fluid durch die Öffnungen strömen kann, Abschnitte sind, die zur Aufnahme einer einzelnen Servervorrichtung bemessen sind.

**7.** Vorrichtung nach einem der vorhergehenden Ansprüche, ferner umfassend, für jede aus der Vielzahl von Öffnungen zu der Ausrüstungsmontagestruktur:

eine Hülse (12), die ausgestaltet ist zur Bildung einer luftdichten Verbindung zwischen der Öffnung und dem Kühlflüssigkeitseinlass der Vorrichtung (20), welche innerhalb des Abschnitts (11), in den die Kühlflüssigkeit durch die Öffnung strömen kann, montiert ist.

**8.** System, umfassend:

eine Ausrüstungsmontagestruktur, die in Abschnitte unterteilt ist, in welche Ausrüstung montiert werden kann; und
eine Vorrichtung zur Regulierung des Stroms der Kühlflüssigkeit zu Ausrüstung, die in der Ausrüstungsmontagestruktur nach einem der Ansprüche 1 bis 7 montiert ist;

**9.** Einen Controller (50) zur Steuerung der Vorrichtung zur Regulierung des Kühlflüssigkeitsstroms zu der in einer Ausrüstungsmontagestruktur (10) montierten Ausrüstung (20), wobei die Vorrichtung für jede aus einer Vielzahl von Öffnungen zu der Ausrüstungsmontagestruktur (10) Folgendes umfasst, wobei Kühlflüssigkeit durch jede Öffnung in einen unterschiedlichen Abschnitt (11) der Ausrüstungsmontagestruktur (10) strömen kann und in Fluidverbindung mit einem Kühlflüssigkeitseinlass (21) der Ausrüstung (20) steht, wenn die Ausrüstung innerhalb des Abschnitts montiert ist:

ein Ventil (30), das wahlweise konfigurierbar ist, um den Durchsatz der Kühlflüssigkeit, die durch die jeweilige Öffnung strömt, zu steuern;
einen Durchflussregler (31) der Kühlflüssigkeit, der mit dem Ventil (30) gekoppelt ist und der betreibbar ist, um das gekoppelte Ventil entsprechend der empfangenen Steuersignale zu konfigurieren, welche in Abhängigkeit von Anzeigen von Betriebszuständen von Ausrüstung (20), die innerhalb des Abschnitts (11) montiert sind, in den die Kühlflüssigkeit durch die Öffnung strömen kann, erzeugt werden;

und ein Kühlflüssigkeitsversorgungssystem, das betreibbar ist, um ein Kühlflüssigkeits-Verteilungsnetz, durch das die Vielzahl von Öffnungen zu der Ausrüstungsmontagestruktur in Fluidverbindung mit dem Kühlflüssigkeitsversorgungssystem steht, zu versorgen;
wobei der Controller (50) betreibbar ist, um Anzeigen von Betriebszuständen von Ausrüstung (20), die innerhalb jedem aus einer Vielzahl von unterschiedlichen Abschnitten (11) der Ausrüstungsmontagestruktur (10) montiert ist, zu empfangen,
um Steuersignale für den Durchflussregler (31) der Kühlflüssigkeit zu erzeugen, welcher mit dem Ventil (30) gekoppelt ist, welches den Durchsatz der Kühlflüssigkeit, die durch die Öffnung in jeden der Vielzahl verschiedener Abschnitte (11) strömt, aufgrund der empfangenen Anzeigen steuert, und um die Steuersignale an die Durchflussregler (31) der Kühlflüssigkeit zu übertragen;
und wobei der Controller (50) betreibbar ist, um den Durchsatz, mit dem das Kühlflüssigkeitsversorgungssystem betreibbar ist, um Kühlflüssigkeit zuzuführen, und die Temperatur der Kühlflüssigkeit, die von dem Kühlflüssigkeitsversorgungssystem zugeführt wird, in Abhängigkeit von den empfangenen Anzeigen von Betriebszuständen der montierten Ausrüstung (20) zu steuern.

**10.** Verfahren zur Steuerung der Vorrichtung zur Regulierung des Kühlflüssigkeitsstroms zu einer in einer Ausrüstungsmontagestruktur (10) montierten Ausrüstung(20), wobei die Vorrichtung für jede aus einer Vielzahl von Öffnungen zu der Ausrüstungsmontagestruktur (10) Folgendes umfasst, wobei Kühlflüssigkeit durch jede Öffnung in einen unterschiedlichen Abschnitt (11) der Ausrüstungsmontagestruktur (10) strömen kann und in Fluidverbindung mit einem Kühlflüssigkeitseinlass (21) der Ausrüstung (20) steht, wenn die Ausrüstung innerhalb des Abschnitts montiert ist:

ein Ventil (30), das wahlweise konfigurierbar ist, um den Durchsatz der Kühlflüssigkeit, die durch die jeweilige Öffnung strömt, zu steuern;
einen Durchflussregler (31) der Kühlflüssigkeit, der mit dem Ventil (30) gekoppelt ist und der betreibbar ist, um das gekoppelte Ventil (30) gemäß den empfangenen Steuersignalen zu konfigurieren, welche in Abhängigkeit von Anzeigen von Betriebszuständen der Ausrüstung (20), die innerhalb des Abschnitts montiert sind, in den die Kühlflüssigkeit durch die Öffnung strömen kann, erzeugt werden;

und ein Kühlflüssigkeitsversorgungssystem, das betreibbar ist, um ein Kühlflüssigkeits-Verteilungsnetz, durch das die Vielzahl von Öffnungen zu der Ausrüstungsmontagestruktur in Fluidverbindung mit dem Kühlflüssigkeitsversorgungssystem steht, zu versorgen;
wobei das Verfahren Folgendes umfasst:

Empfangen von Anzeigen von Betriebszuständen von Ausrüstung (20), die innerhalb von jedem aus einer Vielzahl von unterschiedlichen Abschnitten (11) der Ausrüstungsmontagestruktur (10) montiert ist;
Erzeugen von Steuersignalen für den Durchflussregler (31) der Kühlflüssigkeit, der mit dem Ventil (30) gekoppelt ist, welches den Durchsatz der Kühlflüssigkeit, die durch die Öffnung in jeden der Vielzahl verschiedener Abschnitte (11) strömt, aufgrund der empfangenen Anzeigen steuert;
Übertragen der Steuersignale an die Durchflussregler (31) der Kühlflüssigkeit; und
Steuern des Durchsatzes, mit der das Kühlflüssigkeitsversorgungssystem betreibbar ist, um Kühlflüssigkeit zuzuführen, und der Temperatur der Kühlflüssigkeit, die von dem Kühlflüssigkeitsversorgungssystem zugeführt wird, in Abhängigkeit von den empfangenen Anzeigen von Betriebszuständen der montierten Ausrüstung (20).

**11.** Computerprogramm, das bei der Ausführung durch eine Computervorrichtung bewirkt, dass die Computervorrichtung als Controller nach Anspruch 9 wirkt.

**12.** Computerprogramm, das bei der Ausführung durch eine Computervorrichtung bewirkt, dass die Computervorrichtung ein Verfahren nach Anspruch 10 durchführt.

## Revendications

**1.** Appareil pour réguler l'écoulement d'un fluide de refroidissement vers un équipement (20) monté dans une structure de montage d'équipement (10), l'appareil comprenant, pour chacune d'une pluralité d'ouvertures vers la structure de montage d'équipement, chaque ouverture permettant au fluide de refroidissement de s'écouler dans une section différente de la structure de montage d'équipement et en communication fluidique avec une entrée de fluide de refroidissement (21) de l'équipement lorsque ledit équipement est monté dans cette section :

une vanne (30) pouvant être configurée de manière sélective pour commander le débit du fluide de refroidissement s'écoulant à travers l'ouverture ; et
un régulateur de débit de fluide de refroidissement (31) accouplé à la vanne (30) et pouvant être utilisé pour configurer la vanne (30) accouplée conformément aux signaux de commande reçus générés sur la base d'indications des états de fonctionnement de l'équipement monté dans la section dans laquelle l'ouverture permet au fluide de refroidissement de s'écouler ;
un contrôleur (50) pouvant être utilisé pour recevoir des indications des états de fonctionnement de l'équipement (20) monté dans chacune d'une pluralité de sections (11) différentes de la structure de montage d'équipement (10),
pour générer des signaux de commande pour le régulateur de débit de fluide de refroidissement (31) accouplé à la vanne (30) commandant le débit du fluide de refroidissement s'écoulant à travers l'ouverture dans chacune de la pluralité de sections (11) différentes sur la base des indications reçues, et pour transmettre les signaux de commande aux régulateurs de débit de fluide de refroidissement (31) ;
un système de fourniture de fluide de refroidissement (60) pouvant être utilisé pour fournir un fluide de refroidissement à un réseau de distribution de fluide de refroidissement par lequel la pluralité d'ouvertures vers la structure de montage d'équipement sont en communication fluidique avec le système de fourniture de fluide de refroidissement ;

dans lequel le contrôleur peut être utilisé pour commander le débit auquel le système de fourniture de fluide de refroidissement peut être utilisé pour fournir le fluide de refroidissement, et la température du fluide de refroidissement délivré par le système de fourniture de fluide de refroidissement (60), sur la base des indications reçues des états de fonctionnement de l'équipement monté.

**2.** Appareil selon la revendication 1, comprenant en outre :

un planificateur de charge de travail pouvant être utilisé pour attribuer des tâches à l'équipement monté sur la base d'un coût énergétique calculé de l'attribution par rapport à une ou plusieurs autres attributions possibles, et pour transmettre au contrôleur des données indiquant l'attribution ; dans lequel

le coût énergétique calculé est soit une augmentation prédite d'une charge calorifique, soit une augmentation prédite de la puissance requise pour annuler une augmentation prédite d'une charge calorifique dans l'enceinte.

**3.** Appareil selon l'une quelconque des revendications précédentes, comprenant en outre :

un conduit (40) pour canaliser le fluide de refroidissement provenant d'une entrée (42) en communication fluidique avec un système de fourniture de fluide de refroidissement (60), et avec la pluralité d'ouvertures (41) vers la structure de montage d'équipement.

**4.** Appareil selon la revendication 3, dans lequel le conduit forme un joint étanche à l'air autour d'une sortie de la canalisation à travers laquelle le fluide de refroidissement provenant d'un système de fourniture de fluide de refroidissement est réparti, et forme un joint étanche à l'air autour d'une ou de plusieurs de la pluralité d'ouvertures vers la structure de montage d'équipement, de sorte que le conduit définit un passage étanche à l'air entre la sortie de la canalisation et lesdites une ou plusieurs de la pluralité d'ouvertures.

**5.** Appareil selon l'une quelconque des revendications précédentes, dans lequel
les indications des états de fonctionnement sont fournies par un ou plusieurs dispositifs individuels montés dans la section de la structure de montage d'équipement, et comprennent des indications d'un ou de plusieurs des états de fonctionnement qui suivent :

le débit du fluide de refroidissement à l'entrée vers le dispositif individuel ;
la température du fluide de refroidissement à l'entrée vers le dispositif individuel ;
la puissance dissipée par le dispositif individual ;
la charge de travail du dispositif individuel ; et
la température à l'intérieur du dispositif individuel.

**6.** Appareil selon l'une quelconque des revendications précédentes, dans lequel
les sections de la structure de montage d'équipement dans lesquelles les ouvertures permettent au fluide de s'écouler sont des sections dimensionnées pour recevoir un dispositif serveur unique.

**7.** Appareil selon l'une quelconque des revendications précédentes, comprenant en outre, pour chacune de la pluralité d'ouvertures vers la structure de montage d'équipement :

un manchon (12) configuré pour former une liaison étanche à l'air entre l'ouverture et l'entrée de fluide de refroidissement de l'équipement (20) monté dans la section (11) dans laquelle l'ouverture permet au fluide de refroidissement de s'écouler.

**8.** Système comprenant :

une structure de montage d'équipement divisée en sections dans lesquelles un équipement peut être monté ; et
un appareil pour réguler l'écoulement de fluide de refroidissement vers l'équipement monté dans la structure de montage d'équipement selon l'une quelconque des revendications 1 à 7.

**9.** Contrôleur (50) pour commander un appareil pour réguler l'écoulement de fluide de refroidissement vers un équipement (20) monté dans une structure de montage d'équipement (10), l'appareil comprenant, pour chacune d'une pluralité d'ouvertures vers la structure de montage d'équipement (10), chaque ouverture permettant au fluide de refroidissement de s'écouler dans une section (11) différente de la structure de montage d'équipement (10) et en communication fluidique avec une entrée de fluide de refroidissement (21) de l'équipement (20) lorsque ledit équipement est monté dans cette section :

une vanne (30) pouvant être configurée de manière sélective pour commander le débit du fluide de refroidissement s'écoulant à travers l'ouverture respective ;
un régulateur de débit de fluide de refroidissement (31) accouplé à la vanne (30) et pouvant être utilisé pour configurer la vanne accouplée conformément aux signaux de commande reçus générés sur la base d'indications des états de fonctionnement de l'équipement (20) monté dans la section (11) dans laquelle l'ouverture permet au fluide de refroidissement de s'écouler ;

et un système de fourniture de fluide de refroidissement pouvant être utilisé pour fournir un fluide de refroidissement à un réseau de distribution de fluide de refroidissement par lequel la pluralité d'ouvertures vers la structure de montage d'équipement sont en communication fluidique avec le système de fourniture de fluide de refroidissement ;
dans lequel le contrôleur (50) peut être utilisé pour recevoir des indications des états de fonctionnement de l'équipement (20) monté dans chacune d'une pluralité de sections (11) différentes de la structure de montage d'équipement (10),
pour générer des signaux de commande pour le régulateur de débit de fluide de refroidissement (31) accouplé à la vanne (30) commandant le débit du fluide de refroidissement s'écoulant à travers l'ouverture dans chacune de la pluralité de sections (11) différentes sur la base des indications reçues, et pour transmettre les signaux de commande aux régulateurs de débit de fluide de refroidissement (31) ;
et dans lequel le contrôleur (50) peut être utilisé pour commander le débit auquel le système de fourniture de fluide de refroidissement peut être utilisé pour fournir le fluide de refroidissement, et la température du fluide de refroidissement délivré par le système de fourniture de fluide de refroidissement, sur la base des indications reçues des états de fonctionnement de l'équipement (20) monté.

**10.** Procédé pour commander un appareil pour réguler l'écoulement d'un fluide de refroidissement vers un équipement (20) monté dans une structure de montage d'équipement (10), l'appareil comprenant, pour chacune d'une pluralité d'ouvertures vers la structure de montage d'équipement (10), chaque ouverture permettant au fluide de refroidissement de s'écouler dans une section (11) différente de la structure de montage d'équipement (10) et en communication fluidique avec une entrée de fluide de refroidissement (21) de l'équipement (20) lorsque ledit équipement est monté dans cette section :

une vanne (30) pouvant être configurée de manière sélective pour commander le débit du fluide de refroidissement s'écoulant à travers l'ouverture respective ;
un régulateur de débit de fluide de refroidissement (31) accouplé à la vanne (30) et pouvant être utilisé pour configurer la vanne (30) accouplée conformément aux signaux de commande reçus générés sur la base d'indications des états de fonctionnement de l'équipement (20) monté dans la section dans laquelle l'ouverture permet au fluide de refroidissement de s'écouler ;

et un système de fourniture de fluide de refroidissement pouvant être utilisé pour fournir un fluide de refroidissement à un réseau de distribution de fluide de refroidissement par lequel la pluralité d'ouvertures vers la structure de montage d'équipement sont en communication fluidique avec le système de fourniture de fluide de refroidissement ;
dans lequel le procédé comprend :

la réception d'indications des états de fonctionnement de l'équipement (20) monté dans chacune d'une pluralité de sections (11) différentes de la structure de montage d'équipement (10) ;
la génération de signaux de commande pour le régulateur de débit de fluide de refroidissement (31) accouplé à la vanne (30) commandant le débit du fluide de refroidissement s'écoulant à travers l'ouverture dans chacune de la pluralité de sections (11) différentes sur la base des indications reçues ;
la transmission des signaux de commande aux régulateurs de débit de fluide de refroidissement (31) ; et
la commande du débit auquel le système de fourniture de fluide de refroidissement peut être utilisé pour fournir le fluide de refroidissement, et de la température du fluide de refroidissement délivré par le système de fourniture de fluide de refroidissement, sur la base des indications reçues des états de fonctionnement de l'équipement (20) monté.

**11.** Programme d'ordinateur qui, lorsqu'il est exécuté par un dispositif informatique, amène le dispositif informatique à fonctionner en tant que contrôleur selon la revendication 9.

**12.** Programme d'ordinateur qui, lorsqu'il est exécuté par un dispositif informatique, amène le dispositif informatique à effectuer un procédé selon la revendication 10.

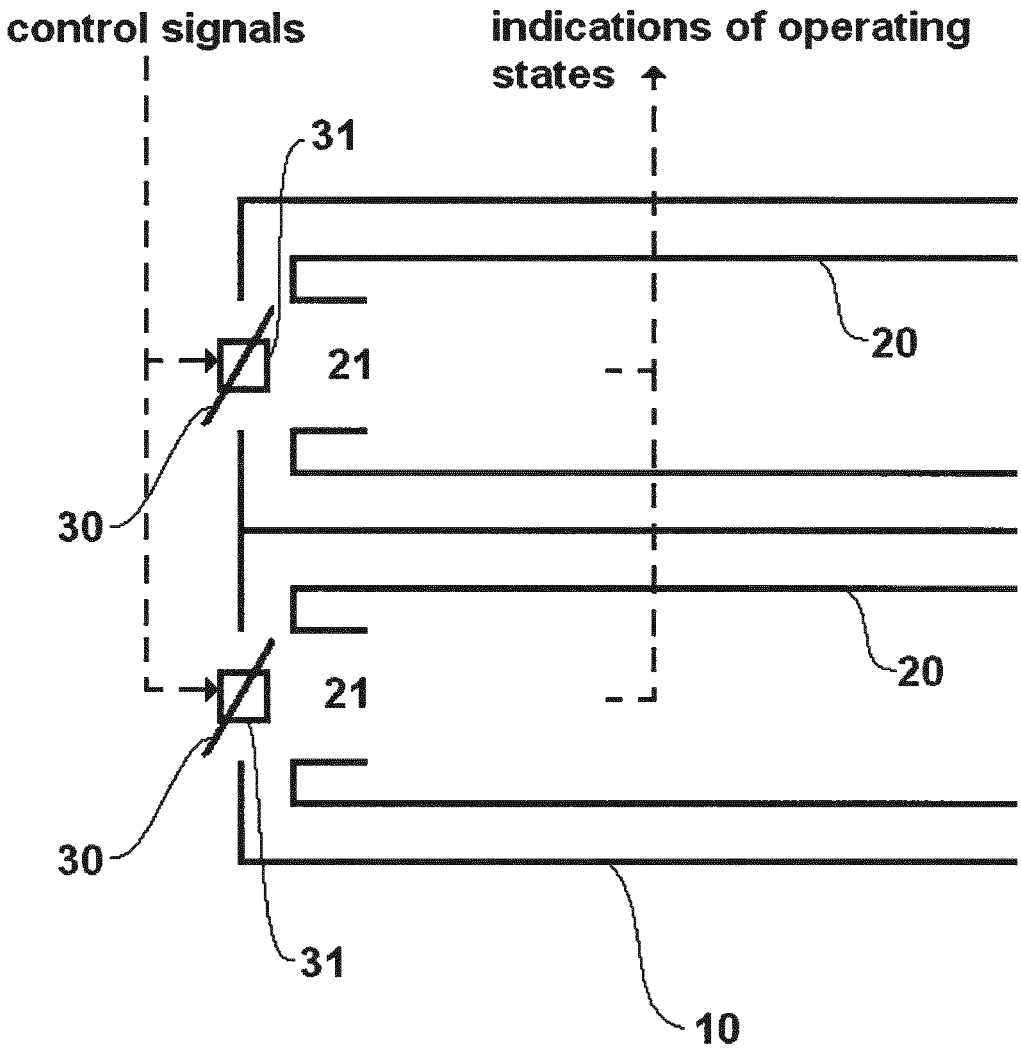
control signals
indications of operating states
31
20
21
30
20
21
30
31
10

FIGURE 1

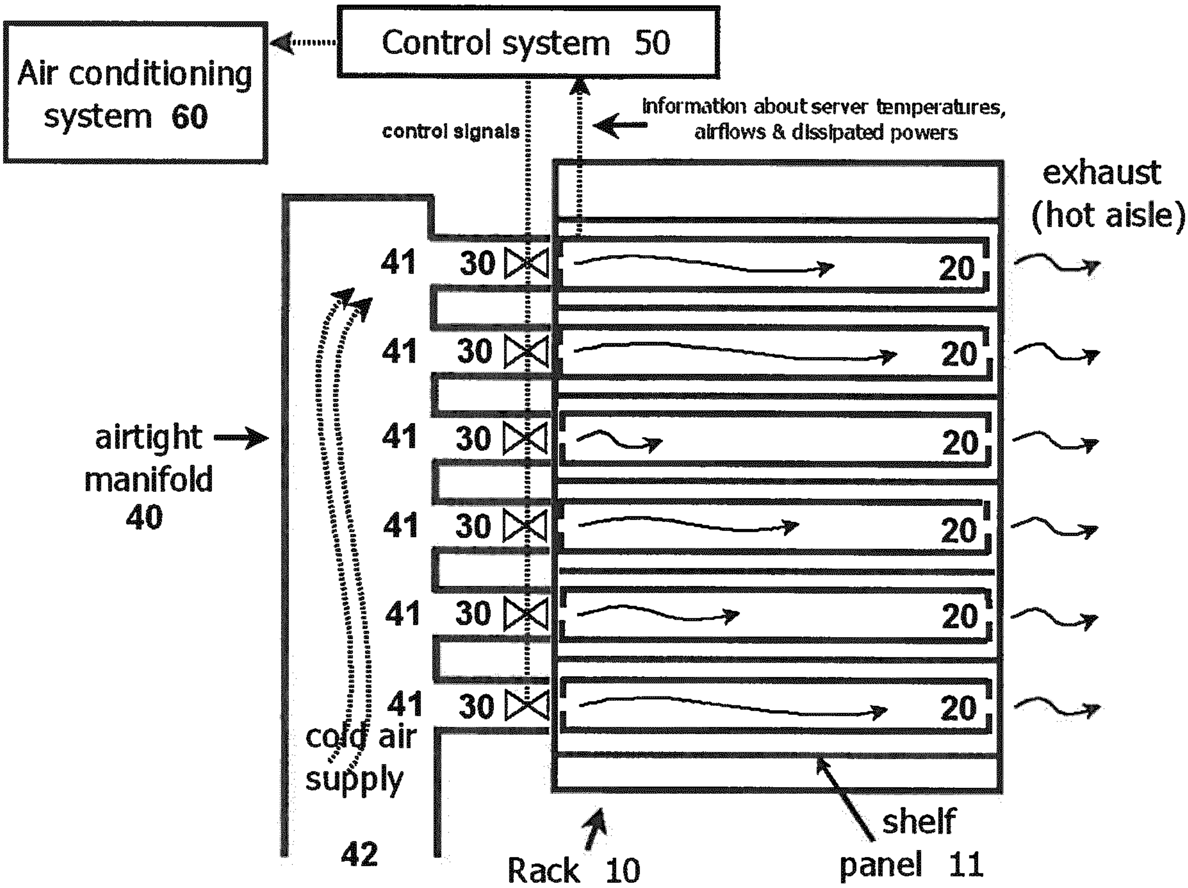
Air conditioning system 60
Control system 50
control signals
information about server temperatures, airflows & dissipated powers
exhaust (hot aisle)
41
30
20
airtight manifold 40
cold air supply
42
Rack 10
shelf panel 11

FIGURE 2

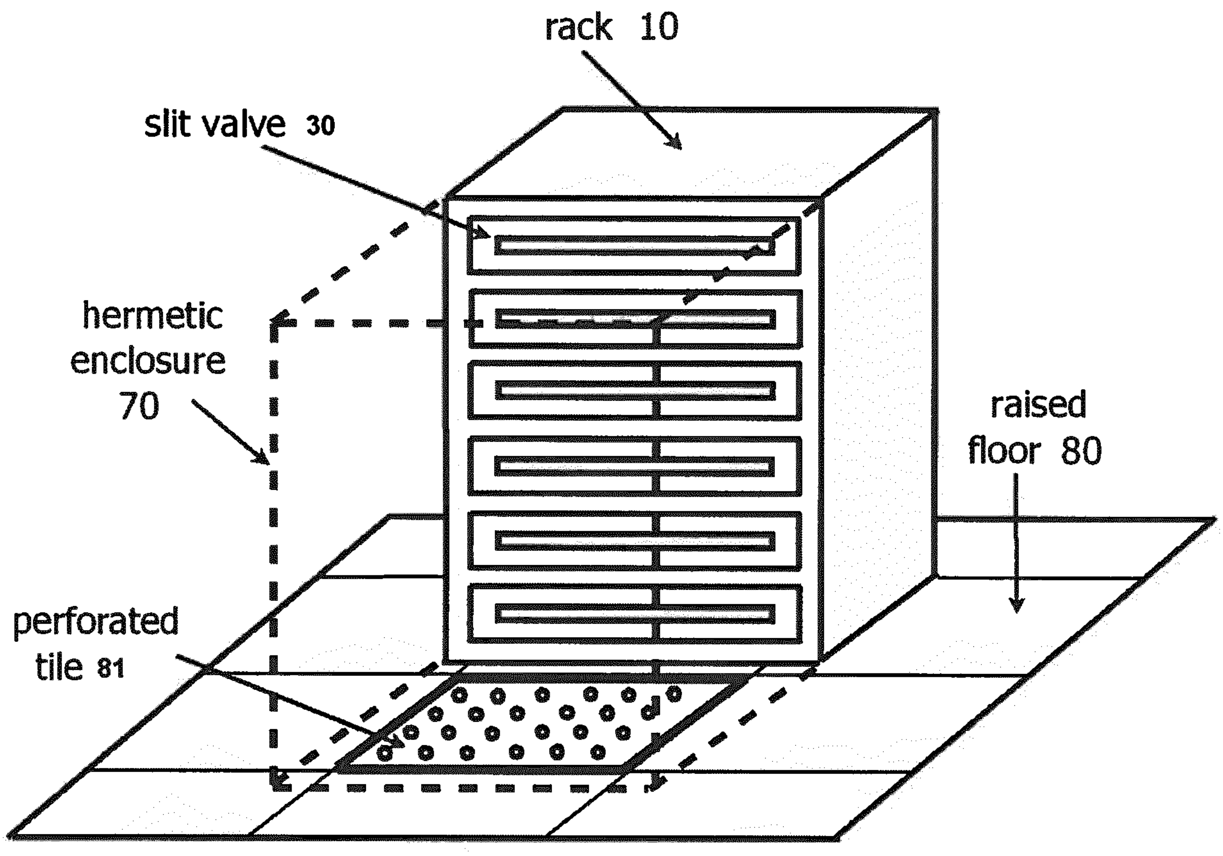
rack 10
slit valve 30
hermetic enclosure 70
raised floor 80
perforated tile 81

FIGURE 3

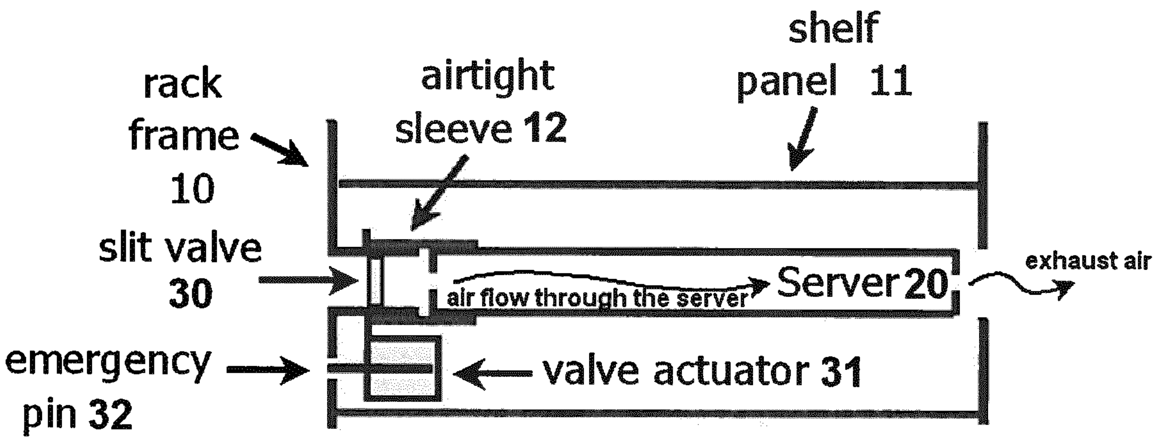
shelf
panel 11
rack
frame
10
airtight
sleeve 12
slit valve
30
air flow through the server
Server 20
exhaust air
emergency
pin 32
valve actuator 31

FIGURE 4

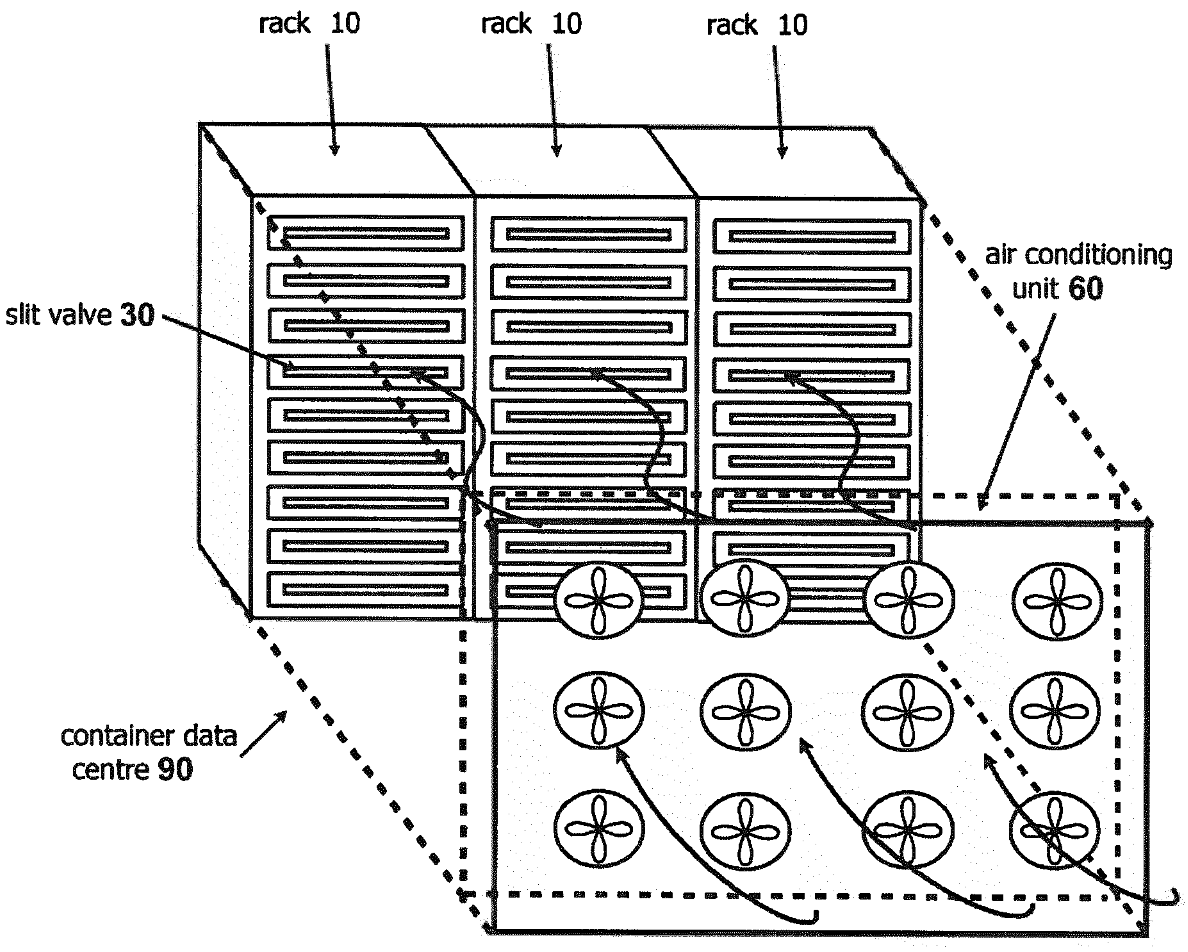
rack 10
rack 10
rack 10
air conditioning unit 60
slit valve 30
container data centre 90

FIGURE 5

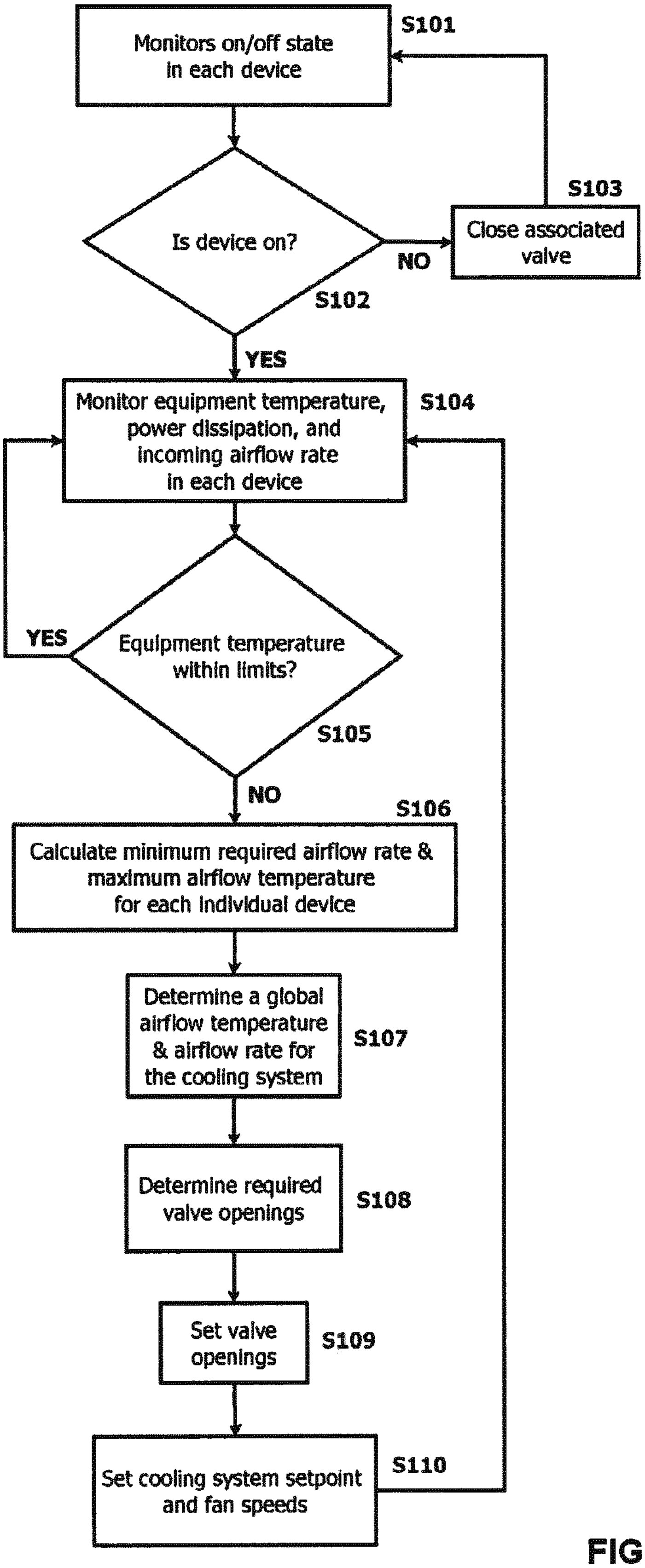
Monitors on/off state in each device
S101
Is device on?
S102
NO
Close associated valve
S103
YES
Monitor equipment temperature, power dissipation, and incoming airflow rate in each device
S104
Equipment temperature within limits?
YES
S105
NO
S106
Calculate minimum required airflow rate & maximum airflow temperature for each individual device
Determine a global airflow temperature & airflow rate for the cooling system
S107
Determine required valve openings
S108
Set valve openings
S109
Set cooling system setpoint and fan speeds
S110

FIGURE 6

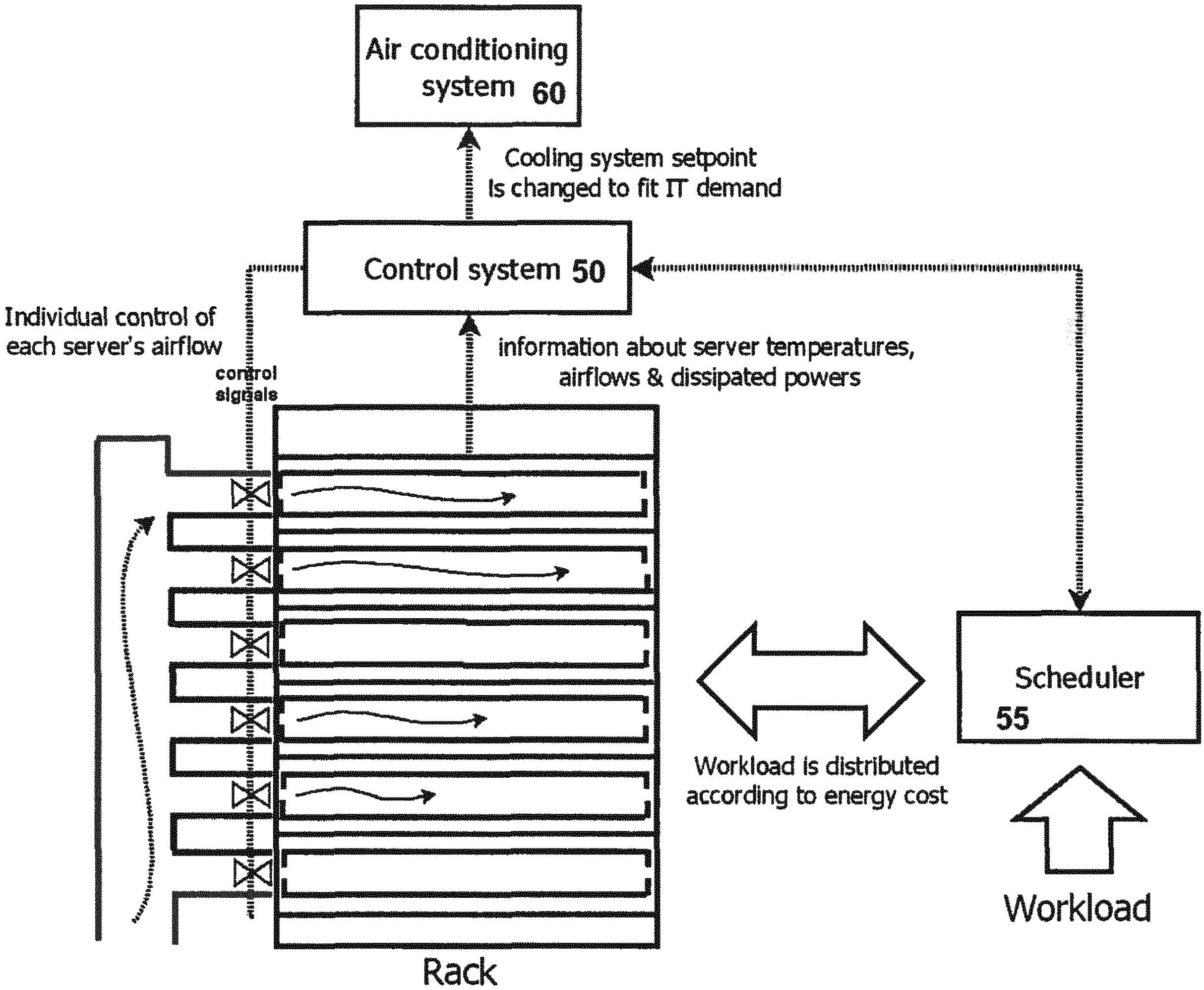
Air conditioning system 60
Cooling system setpoint Is changed to fit IT demand
Control system 50
Individual control of each server's airflow
control signals
information about server temperatures, airflows & dissipated powers
Scheduler 55
Workload is distributed according to energy cost
Workload
Rack

FIGURE 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2009097203 A1
- GB 2402816 A
- US 2009122484 A1
- US 2010313203 A1
- EP 11194408 A